## Europäisches Patentamt
## European Patent Office
## Office européen des brevets

(19)

(11) Veröffentlichungsnummer: **0 127 172**
**B1**

(12) **EUROPÄISCHE PATENTSCHRIFT**

(45) Veröffentlichungstag der Patentschrift: **14.03.90**

(21) Anmeldenummer: **84106086.6**

(22) Anmeldetag: **28.05.84**

(51) Int. Cl.⁵: **H 03 K 5/14**

य़

(54) **Schaltungsanordnung für die Verschiebung der Phase eines Taktsignals.**

(30) Priorität: **31.05.83 DE 3319762**

(43) Veröffentlichungstag der Anmeldung:
**05.12.84 Patentblatt 84/49**

(45) Bekanntmachung des Hinweises auf die
Patenterteilung:
**14.03.90 Patentblatt 90/11**

(84) Benannte Vertragsstaaten:
**AT BE CH DE FR GB IT LI NL SE**

(56) Entgegenhaltungen:
**US-A-2 910 586**
**US-A-3 883 810**
**US-A-4 290 022**

**PATENTS ABSTRACTS OF JAPAN, Band 5, Nr.
181 (E-83)853r, 20. November 1981; & JP-A-56
107 630 (NIPPON DENKI K.K.) 26-08-1981**

**Idem**

(73) Patentinhaber: **Siemens Aktiengesellschaft
Wittelsbacherplatz 2
D-8000 München 2 (DE)**

(72) Erfinder: **Schollmeier, Gero, Dr. Ing.
Frühlingsstrasse 6
D-8035 Gauting (DE)**
Erfinder: **Sailer, Heinrich, Dipl.-Ing.
Michlbauerstrasse 3
D-8021 Neuried (DE)**

(56) Entgegenhaltungen:
**ELECTRONIC DESIGN, Band 19, Nr. 14, 8. Juli
1971, Seite 78, Rochelle Park, US; S.K. KAN et
al.: "Programmable phase shifter operates from
dc to 100 kHz"**

## Beschreibung

Die Erfindung betrifft eine Schaltungsanordnung für die Verschiebung einer PHase eines Taktsignals in einer Taktsignalerzeugungsschaltung mit einem das Taktsignal abgebenden Taktoszillator, einer eine Mehrzahl von Ausgängen aufweisenden Taktsignalverteilerschaltung, welche das von dem Taktoszillator abgegebene Taktsignal zugeführt erhält und von diesem abgeleitete Taktsignale mit stets gleicher Frequenz und mit in einem festen ersten Raster liegenden, zueinander verschobenen Phasen an seinen Ausgängen abgibt, und mit einer die Phasenregelung bewirkenden Steueranordnung, welche einen der Ausgänge der Taktsignalverteilerschaltung auswählt.

Die Phasenregelung eines Taktsignals in digitalen Phasenregelanordnungen erfolgt Üblicherweise dadurch, daß das Taktsignal im Raster eines der Phasenergelanordnung zugeführten Eingangstaktsignals verschoben wird. Die Auflösung der Phasenverschiebung entspricht dabei maximal einer Periode der Eingangstaktfrequenz. Wird eine hohe Auflösung gefordert, so wäre diese beispielsweise dadurch resilisierbar, daß der betreffenden Phasenregelanordnung eine entsprechend hohe Eingangstaktfrequenz zugeführt wird. Soll beispielsweise eine Frequenz von 100 kHz mit einer Auflösung der Phase von einem Promille digital geregelt werden, so wäre eine Eingangstaktfrequenz von 100 MHz erforderlich. Eine derart hohe Eingangstaktfrequenz kann aber mit üblichen hochintegrierten Schaltkreisen der Digitaltechnik nicht mehr verarbeitet werden.

Bekannte Schaltungsanordnungen der eingangs genannten Art (US—A—4 290 022; Patent Abstracts of Japan, Band 5, Nr. 181 (E-83), (853), 20. November 1981, JP—A—56—107630) weisen jeweils eine aus einer Laufzeitkette oder aus einem Schieberegister gebildete Taktsignalverteilerschaltung auf. Bei Verwendung eines Schieberegisters kann eine hohe Auflösung der Phasenverschiebung lediglich dadurch erreicht werden, daß dem Schieberegister eine entsprechend hohe Taktfrequenz zugeführt wird. Dabei kann eine hohe Eingangstaktfrequenz dazu führen, daß diese nicht mehr mit üblichen Schaltkreisen der Digitaltechnik verarbeitet werden kann.

Bei Verwendung einer Laufzeitkette als Taktsignalverteilerschaltung kann dagegen die Auflösung der Phasenverschiebung durch die Signallaufzeiten innerhalb der einzelnen Laufzeitglieder und die Länge dieser Laufzeitkette festgelegt werden. Bei einer geforderten hohen Auflösung führt dies jedoch zu einer erheblichen Länge einer solchen Laufzeitkette.

Der Erfindung liegt nun die Aufgabe zugrunde, einen Weg zu zeigen, wie bei einer Schaltungsanordnung der eingangs betrachteten Art die Verschiebung der Phase mit einer hohen Auflösung bei einer relativ niedrigen Eingangstaktfrequenz realisiert werden kann.

Gelöst wird die vorstehend aufgezeigte Aufgabe bei einer Schaltungsanordnung der eingangs genannten Art gemäß der vorliegenden Erfindung dadurch, daß der durch die Steueranordnung ausgewählte Ausgang der Taktsignalverteilerschaltung mit einer eine Anzahl von in Reihe geschalteten Laufzeitgliedern aufweisenden Laufzeitkette verbunden ist, deren Laufzeitglieder ausgangsseitig Taktsignale mit in einem gegenüber dem ersten Raster um einen bestimmten Faktor engeren zweiten Raster liegenden, zueinander verschobenen Phasen abgeben, und daß jeweils ein durch die Steueranordnung ausgewähltes Laufzeitglied der Laufzeitkette das durch die Taktsignalverteilerschaltung und die Laufzeitkette in seiner Phase verschobene Taktsignal ausgangsseitig abgibt.

Die Erfindung bringt den Vorteil mit sich, daß eine Phasenverschiebung mit einer hohen Auflösung durch eine einen relativ geringen schaltungstechnischen Aufwand aufweisende Schaltungsanordnung erzeugt werden kann, der lediglich eine von üblichen Schaltkreisen der Digitaltechnik verarbeitbare Eingangstaktfrequenz zugeführt werden braucht. Soll beispielsweise mit dieser Schaltungsanordnung eine Taktfrequenz von 100 kHz mit einer Auflösung der Phase von einem Promille geregelt werden, so ist es beispielsweise ausreichend, der Taktsignalverteilerschaltung ein Eingangstaktsignal mit einer Frequenz von 10 MHz zuzuführen. Bei diesem Eingangstaktsignal treten an den Ausgängen der Taktsignalverteilerschaltung dann Taktsignale auf, deren Phasen um 1% voneinander abweichen. Dieses zunächst grobe Phasenraster wird mit Hilfe der mit jedem der Ausgänge der Taktsignalverteilerschaltung verbindbaren Laufzeitkette feiner unterteilt. Für das hier betrachtete Beispiel wird die geforderte Auflösung von eines Promille durch Laufzeitglieder erreicht, die jeweils eine interne Signallaufzeit von 10 Nanosekunden hervorrufen. Mit der erfindungsgemäßen Schaltungsanordnung ist somit die als Beispiel gewählte Phasenverschiebung um ein Promille mit einer Eingangstaktfrequenz erreichbar, die um den Faktor 10 niedriger liegt als die bei dem eingangs betrachteten Verfahren erforderliche Eingangstaktfrequenz.

Für eine monotone Verschiebung der Phase des Taktsignals über einen Rasterschritt des ersten Rasters hinaus ist es zweckmäßig, daß die Laufzeitkette eingangsseitig über einen ersten Auswahlschalter an Ausgänge der Taktsignalverteilerschaltung angeschlossen ist, daß die Ausgänge der Laufzeitglieder der Laufzeitkette über einen zweiten Auswahlschalter mit einem Taktsignalausgang verbunden sind, daß mit dem zweiten Auswahlschalter eine Auswertsanordnung verbunden ist, die das ihr über den zweiten Auswahlschalter zugeführte Taktsignal mit demjenigen von der Taktsignalverteilerschaltung abgegebenen Taktsignal vergleicht, dessen Phase gegenüber der des en die Laufzeitkette abgegebenen Taktsignals um einen einzigen Rasterschritt des ersten Rasters verschoben ist und daß die Auswerteanordnung immer dann ein für die Umschaltung des ersten und zweiten Auswahlschalters dienendes Steuersignal an die Steueranordnung abgibt, wenn die Phase des ihr über den zweiten Auswahlschalter zugeführten Taktsignals gleich oder größer als die Phase des als Vergleichssignal dienenden Taktsignals ist. Dies bringt den Vorteil mit sich, daß für eine monotone Verschiebung der Phase über einen Rasterschritt des ersten Rasters hinaus die Laufzeitkette keine bezüglich ihrer internen Laufzeit exakt abgeglichenen Laufzeitglieder aufzuweisen braucht. Es ist lediglich eine genügend große Anzahl von Laufzeitgliedern vorzusehen, um auch bei einer minimalen Laufzeit innerhalb der einzelnen Laufzeitglieder eine Gesamtphasenverschiebung zu erhalten, die nicht geringer ist als ein Rasterschritt des ersten Rasters.

Weitere zweckmäßige Ausgestaltungen der Schaltungsanordnung gemäß der Erfindung ergeben sich aus den Unteransprüchen 3 bis 5.

Anhand von Zeichnungen wird die Erfindung nachstehend beispielsweise näher erläutert.

Fig. 1 zeigt in einem Blockschaltbild eine Schaltungsanordnung, bei der die Erfindung angewandt ist,

Fig. 2 zeigt ein Diagramm, auf das im Zuge der Erläuterung der Erfindung eingegangen wird.

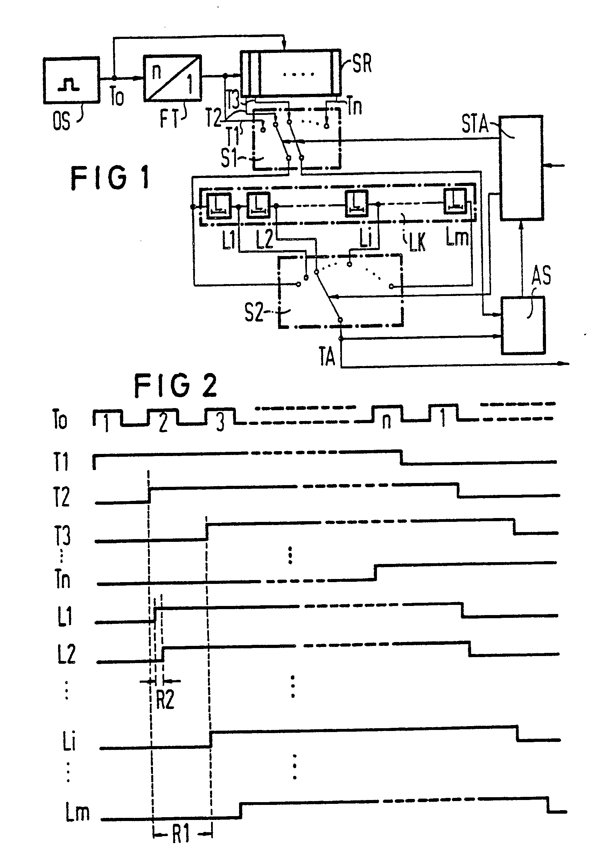

In Fig. 1 ist eine Taktsignalerzeugungsschaltung dargestellt, wie sie beispielsweise in Phasenregelanordnungen verwendet werden kann. Diese Taktsignalerzeugungsschaltung weist einen Taktoszillator OS auf, der mit seinem Ausgang einerseits mit einem Frequenzteiler FT und andererseits mit einem Signaleingang eines Schieberegisters SR verbunden ist. An einen weiteren Signaleingang des Schieberegisters ist der Ausgang des Frequenzteilers FT angeschlossen. Dieser Ausgang T1 und die parallelen Ausgänge T2 bis Tn der Schieberegisters sind mit Eingängen eines ersten Auswahlschalters S1 verbunden. Dieser erste Auswahlschalter, der von einer Steueranordnung STA her steuerbar ist, weist zwei Ausgänge auf, wobei der erste Ausgang jeweils nur einen seiner Eingänge mit dem Eingang einer eine Anzahl von in Reihe geschalteten Laufzeitgliedern L aufweisenden Laufzeitkette LK verbindet. Über den zweiten Ausgang ist der dem gerade mit dem Eingang der Laufzeitkette verbundenen Ausgang nachfolgende Ausgang des Schieberegisters SR an den Eingang einer Auswerteanordnung AS angeschaltet. In Fig. 1 ist der erste Auswahlschalter S1 lediglich schematisch dargestellt. Er kann aus beliebigen steuerbaren elektronischen Schalterelementen, wie z.B. Schalttransistoren oder digitalen Verknüpfungsschaltkreisen, aufgebaut sein.

Der Eingang der bereits erwähnten Laufzeitkette LK und die Ausgänge L1 bis Lm der der Laufzeitkette zugehörigen Laufzeitglieder sind mit Eingängen eines zweiten Auswahlschalters S2 verbunden. Durch diesen zweiten Auswahlschalter, der ebenfalls von der Steueranordnung STA her steuerbar ist und wie der erste Auswahlschalter S1 aus beliebigen steuerbaren elektronischen Schalterelementen aufgebaut sein kann, wird lediglich einer der Ausgänge der Laufzeitkette zur Abgabe eines Taktsignals an einen Taktsignalausgang TA angeschaltet. Dieses von dem zweiten Auswahlschalter abgegebene Taktsignal wird außerdem einem weiteren Eingang der bereits erwähnten Auswerteanordnung AS zugeführt. Diese Auswerteanordnung ist ausgangsseitig zur Abgabe eines Steuersignals mit der Steueranordnung STA verbunden.

Nachdem zuvor der Aufbau der in Fig. 1 dargestellten Taktsignalerzeugungsschaltung erläutert worden ist, wird nun noch auf die Wirkungsweise dieser Schaltungsanordnung unter Bezugnahme auf die Fig. 1 und 2 näher eingegangen. Vom Taktoszillator OS wird an seinem Ausgang T0 ein Taktsignal abgegeben, wie es in Fig. 2 als T0 dargestellt ist. Dieses Taktsignal wirk durch den nachgeschalteten Frequenzteiler FT in seiner Frequenz um den Faktor n heruntergesetzt. Das daraus resultierende Taktsignal (T1 in Fig. 2) wird dem Schieberegisters SR zugeführt. Außerdem wird dem Schieberegister das von dem Taktoszillator abgegebene Taktsignal als Schiebetakt zugeführt. An den Ausgängen des Schieberegisters treten damit Taktsignale auf, wie sie in Fig. 2 als T2 bis Tn dargestellt sind. Diese Taktsignale stellen eine Folge von Taktsignalen mit stets gleicher Frequenz und mit in einem festen ersten Raster liegenden, zueinander verschobenen Phasen dar. In Fig. 2 ist ein Rasterschritt dieses Rasters eingezeichnet (R1).

Die Steueranordnung STA, die von entsprechenden Einrichtungen der Phasenregelanordnung Regelinformationen zur Regelung der Phase zugeführt erhält, wählt mit Hilfe des ersten Auswahlschalters S1 eines der von dem Schieberegister SR abgegebenen, den Regelinformationen entsprechendes Taktsignal aus. Dieses möge beispielsweise das Taktsignal T2 sein. Außerdem wird das Taktsignal T3 über den ersten Auswahlschalter an die Auswerteanordnung AS abgegeben. Das Taktsignal T2 wird dann durch die einzelnen Laufzeitglieder L der Laufzeitkette LK derart verzögert, daß an ihren Ausgängen die in Fig. 2 mit L1 bis Lm bezeichneten Taktsignale auftreten. Die Laufzeiten der einzelnen Laufzeitglieder sind dabei so gewählt, daß an ihren Ausgängen Taktsignale mit zueinander verschobenen Phasen auftreten, die in eines gegenüber des ersten Raster um einen bestimmten Faktor engeren zweiten Raster liegen. In Fig. 2 ist ein Rasterschritt des zweiten Rasters angedeutet und mit R2 bezeichnet.

Die Steueranordnung STA wählt wiederum entsprechend der ihr zugeführten Regelinformationen mit Hilfe des zweiten Auswahlschalters S2 eines der gerade erwähnten Taktsignale aus, welches dann als Ausgangstaktsignal an dem Taktsignalausgang TA abgegeben wird. Dieses Taktsignal, bei dem es sich, wie in Fig. 1 dargestellt, um das Taktsignal L2 handeln möge, wird außerdem in der Auswerteanordnung AS ständig mit dem an dem zweiten Ausgang des ersten Auswahlschalters S1 abgegebenen Taktsignal verglichen. Bei dem hier betrachteten Beispiel handelt es sich um das Taktsignal T3. Die Auswerteanordnung AS vergleicht ständig die Phasen der Eingangssignale und gibt immer dann ein Steuersignal an die Steueranordnung STA ab, wenn die Phase des Ausgangstaktsignals (TA) gleich oder größer als die Phase des von dem ersten Auswahlschalter S1 als Vergleichssignal abgegebenen Taktsignals ist. Das Ausgangstaktsignal ist in diesem Fall in seiner Phase gegenüber dem der Laufzeitkette zugeführten Taktsignal um mindestens einen Rasterschritt des ersten Rasters verschoben. In Fig. 2 trifft dies für das mit Li bezeichnete Taktsignal zu.

Auf ein von der Auswerteanordnung AS abgegebenes Steuersignal hin schaltet die Steueranordnung STA den ersten Auswahlschalter S1 so um, daß der dem gerade mit der Laufzeitkette LK verbundenen Ausgang (T2) nachfolgende Ausgang (T3) nunmehr mit dem Eingang der Laufzeitkette verbunden ist. Gleichzeitig wird auch der an die Auswerteanordnung As angeschlossene Ausgang des ersten Auswahlschalters in entsprechender Weise umgeschaltet. Damit wird an die Laufzeitkette und an die Auswerteanordnung jeweils ein Taktsignal abgegeben, welches gegenüber dem bisher abgegebenen Taktsignal eine um einen Rasterschritt des ersten Rasters vergrößerte Phase aufweist. Außerdem wird auch der zweite Auswahlschalter S2 durch die Steueranordnung STA so umgesteuert, daß er nunmehr an seinem Ausgang der Laufzeitkette zugeführte Taktsignal abgibt. Nach der Umschaltung der beiden Auswahlschalter erfolgt dann innerhalb des ausgewählten Rasterschrittes des ersten Rasters (R1 in Fig. 2) die Auswahl der Phase in der bereits oben dargestellten Weise.

Es kenn nun auch der Fall eintreten, daß für die Phasenregelung ein Taktsignal erforderlich ist, dessen Phase kleiner ist als die des gerade abgegebenen Taktsignals. Liegt dieses für die Regelung erforderliche Taktsignal mit seiner Phase dabei innerhalb des durch den ersten Auswahlschalter ausgewählten Rasterschrittes des ersten Rasters, so erfolgt die Verschiebung ausschließlich durch entsprechende Einstellung des zweiten Auswahlschalters S2. Anderenfalls wird die Phase des Taktsignals zunächst durch eine entsprechende Ansteuerung des ersten Auswahlschalters S1 um ein oder mehrere Rasterschritte des ersten Rasters verkleinert. Denach erfolgt die Feineinstellung der Phase wieder mit Hilfe des zweiten Auswahlschalters S2.

Bisher wurde lediglich ausgeführt, daß die beiden Auswahlschalter S1, S2 von der Steueranordnung STA her zur Auswahl eines Taktsignals eingestellt werden. Dies kann nun je nach Ausführung der Auswahlschalter und der Steueranordnung entweder durch ein von der Steueranordnung gesteuertes schrittweises Weiterschalten der Auswahlschalter in der einen oder anderen Richtung oder durch direkte Auswahl der einzelnen Schalterstufen erfolgen. In beiden Fällen erhält die Steueranordnung dazu entsprechende Regelinformationen von mit ihr verbundenen Phasenregeleinrichtungen zugeführt.

Bezüglich der Dimensionierung der in Fig. 1 dargestellten Schaltungsteile sei hier noch angemerkt, daß beispielsweise für die Abgabe eines Taktsignals mit einer Frequenz von 100 kHz und mit einer im Raster von einem Promille verschiebbare Phase ein Taktoszillator OS verwendet werden kann, der ein Taktsignal mit einer Taktfrequenz von 10 MHz abgibt. Ein nachgeschalteter Frequenzteiler FT mit einem Teilerverhältnis von 100:1 setzt dieses Taktsignal auf die gewünschte Frequenz von 100 kHz um. Wird das auf diese Weise in seiner Frequenz heruntergesetzte Taktsignal einem aus 100 Stufen bestehenden Schieberegister SR zugeführt, so gibt dieses an seinen Ausgängen Taktsignale ab, die alle die gleiche Frequenz von 100 kHz und in einem Raster von 1% verschobene Phasen aufweisen. Werden schließlich für die Laufzeitkette LK Laufzeitglieder L mit einer internen Laufzeit von 10 Nanosekunden verwendet, so kann jeder Rasterschritt des von dem Schieberegister erzeugten Rasters nochmals in zehn Rasterschritte unterteilt werden. Damit verden von den Ausgängen der Laufzeitkette Taktsignale abgeben, die in ihrer Phase mit der oben angegebenen Genauigkeit verschoben werden können. Für die Erzeugung von Laufzeiten im Bereich von Nanosekunden können im übrigen übliche Schaltkreise der Digitaltechnik verwendet werden.

Abschließend sei hier noch angemerkt, daß an Stelle des in Fig. 1 dargestellten Schieberegisters SR auch ein umlaufender Binärzähler mit die Zählerstände anzeigenden Ausgängen einsetzbar ist.

**Patentansprüche**

1. Schaltungsanordnung für die Verschiebung einer Phase eines Taktsignals in einer Taktsignalerzeugungsschaltung mit einem das Taktsignal abgebenden Taktoszillator (OS), einer eine Mehrzahl von Ausgängen aufweisenden Taktsignalverteilerschaltung (SR), welche das von dem Taktoszillator abgegebene Taktsignal (T1) zugeführt erhält und von diesem abgeleitete Taktsignale (T2, T3,...Tn) mit stets gleicher Frequenz und mit in einem festen ersten Raster liegenden, zueinander verschobenen Phasen an seinen Ausgängen abgibt, und mit einer die Phasenregelung bewirkenden Steueranordnung (STA) welche einen der Ausgänge (z.B. T2) der Taktsignalverteilerschaltung (SR) auswählt, dadurch gekennzeichnet, daß der durch die Steueranordnung (STA) ausgewählte Ausgang der Taktsignalverteilerschaltung mit einer eine Anzahl von in Reihe geschalteten Laufzeitgliedern (L) aufweisenden Laufzeitkette (LK) verbunden ist, deren Laufzeitglieder ausgangsseitig Taktsignale (L1, L2,..., Li,..., Lm) mit in einem gegenüber dem ersten Raster um einen bestimmten Faktor engeren zweiten Raster liegenden, zueinander verschobenen Phasen abgeben, und daß jeweils nur ein durch die Steueranordnung (STA) ausgewähltes Laufzeitglied (z.B. L2) der Laufzeitkette das durch die Taktsignalverteilerschaltung (SR) und die Laufzeitkette (LK) in seiner Phase verschobene Taktsignal ausgangsseitig abgibt.

2. Schaltungsanordnung nach Anspruch 1, dadurch gekennzeichnet, daß die Laufzeitkette (LK) eingangsseitig über einen ersten Auswahlschalter (S1) an den Ausgängen der Taktsignalverteilerschaltung (SR) angeschlossen ist, daß die Ausgänge der Laufzeitglieder (L) der Laufzeitkette über einen zweiten Auswahlschalter (S2) mit einem Taktsignalausgang (TA) verbunden sind, daß mit dem zweiten Auswahlschalter (S2) eine Auswerteanordnung (AS) verbunden ist, die das ihr über den zweiten Auswahlschalter zugeführte Taktsignal mit demjenigen von der Taktsignalverteilerschaltung abgegebenen Taktsignal (T3) vergleicht, dessen Phase gegenüber der des an die Laufzeitkette abgegebenen Taktsignals (T2) um einen einzigen Rasterschritt des ersten Rasters verschoben ist und daß die Auswerteanordnung immer dann ein für die Umschaltung des ersten und zweiten Auswahlschalters (S1 und S2) dienendes Steuersignal an die Steueranordnung (STA) abgibt, wenn die Phase des ihr über den zweiten Auswahlschalter zugeführten Taktsignals gleich oder größer als die Phase des als Vergleichssignal dienenden Taktsignals (T3) ist.

3. Schaltungsanordnung nach Anspruch 1 oder 2, dadurch gekennzeichnet, daß die Taktsignalverteilerschaltung (SR) aus einem mehrstufigen Schieberegisters gebildet ist.

4. Schaltungsanordnung nach Anspruch 1 oder 2, dadurch gekennzeichnet, daß die Taktsignalverteilerschaltung (SR) aus einem umlaufenden Binärzähler mit die Zählerstände anzeigenden Ausgängen gebildet ist.

5. Schaltungsanordnung nach einem der Ansprüche 1 bis 4, dadurch gekennzeichnet, daß als Laufzeitglieder (L) der Laufzeitkette (LK) digitale Schaltkreise mit einer für die Erzielung der Phasenverschiebung entsprechenden internen Signallaufzeit benutzt sind.

**Revendications**

1. Montage pour décaler une phase d'un signal de cadence dans un circuit de production de signaux de cadence comportant un oscillateur (OS) réglant la cadence et délivrant le signal de cadence, un circuit (SR) de répartition des signaux de cadence qui comporte une multiplicité de sorties, qui reçoit le signal de cadence (T1) délivré par l'oscillateur réglant la cadence et qui délivre, sur ses sorties, des signaux de cadence (T2, T3...Tn) dérivés de ce signal de cadence et possédant toujours la même fréquence et des phases décalées entre elles et situées dans une première trame fixe, et un dispositif de commande (STA), qui réalise la régulation de phase et sélectionne l'une des sorties (par exemple T2) du circuit (SR) de répartition des signaux de cadence, caractérisé par le fait que la sortie du circuit de répartition des signaux de cadence, qui est sélectionnée par le dispositif de commande (STA), est reliée à une ligne à retard (LK), qui possède un certain nombre de circuits de retard (L) branchés en série, qui délivrant, sur leurs sorties, dans signaux de cadence (L1, L2,...Li,...,Lm) possédant des phases décalées les unes par rapport aux autres et situées dans une seconde trame, réduite d'un facteur déterminé par rapport à la première trame, et que respectivement seul un circuit de retard (par exemple L2) de la ligne à retard, sélectionné par le dispositif de commande (STA), délivre sur sa sortie le signal de cadence, dont la phase est décalée par le circuit (SR) de répartition des signaux de cadence et par la ligne à retard (LK).

2. Montage suivant la revendication 1, caractérisé par le fait que la ligne à retard (LK) est raccordée, côté entrée, par l'intermédiaire d'un premier commutateur de sélection (S1), aux sorties du circuit (SR) de répartition des signaux de cadence, que les sorties des circuits de retard (L) de la ligne à retard sont reliées par l'intermédiaire d'un second commutateur de sélection (S2) à une sortie (TA) des signaux de cadence, qu'au second commutateur de sélection (S2) est relié un dispositif d'évaluation (AS) qui compare le signal de cadence, qui lui est envoyé par l'intermédiaire du second commutateur de sélection, au signal de cadence (T3), qui est délivré par le circuit de répartition des signaux de cadence et dont la phase est décalée, d'un pas unique de la première trame, par rapport à la phase du signal de cadence (T2) envoyé à la ligne à retard, et que le dispositif d'évaluation envoie en permanence un signal de commande, qui est utilisé pour commuter les premier et second commutateurs de sélection (S1 et S2), au dispositif de commande (STA) lorsque la phase du signal de cadence, qui lui est envoyée par l'intermédiaire du second commutateur de sélection, est égale ou supérieure à la phase du signal de cadence (T3) utilisé comme signal de comparaison.

3. Montage suivant la revendication 1 ou 2, caractérisé par le fait que le circuit (SR) de réparatition des signaux de cadence est formé par un registre à décalage à plusieurs étages.

4. Montage suivant la revendication 1 ou 2, caractérisé par le fait que le circuit (SR) de répartition des signaux de cadence est formé à partir d'un compteur binaire à circulation, comportant des sorties affichant les états de comptage.

5. Montage suivant l'une des revendications 1 à 4, caractérisé par le fait qu'on utilise, comme circuits de retard (L) de la ligne à retard (LK), des circuits numériques, comportant un temps de propagation interne des signaux, approprié pour l'obtention du déphasage.

**Claims**

1. Phase shifting circuit for a clock signal in a clock signal generation circuit having a clock oscillator (OS) emitting the clock signal, a clock signal distribution circuit (SR) having a plurality of outputs and receiving the clock signal (11) emitted by the clock oscillator, and outputting at its outputs clock signals (T2, T3,...Tn) derived therefrom, always at the same frequency and with mutually shifted phases lying in a fixed first grid, and having a control arrangement (STA) effecting the phase control which selects one of the outputs (e.g. T2) of the clock signal distribution circuit (SR), characterized in that the output of the clock signal distribution circuit selected by the control arrangement (STA) is connected to a delay line (LK) having a number of series-connected delay elements (L), which delay elements emit at the output side clock signals (L1, L2,..., Li,...Lm) with mutually shifted phases lying in a second grid narrower by a given factor with respect to the first grid, and in that in each case only one delay element (e.g. L2) of the delay line selected by the control arrangement (STA) outputs at the output side the clock signal that is phase-shifted by the clock signal distribution circuit (SR) and the delay line (LK).

2. Circuit according to Claim 1, characterized in that the delay line (LK) is connected at the input side via a first selection switch (S1) to the outputs of the clock signal distribution circuit (SR), in that the outputs of the delay elements (L) of the delay line are connected via a second selection switch (S2) to a clock signal output (TA), in that there is connected to the second selection switch (S2) an evaluation arrangement (AS) which compares the clock signal supplied to it via the second selection switch to that clock signal (T3) emitted by the clock signal distribution circuit, the phase of which clock signal (T3) is shifted by a single grid step of the first grid with respect to the clock signal (T2) emitted to the delay line, and in that the evaluation arrangement always emits a control signal responsible for switching over the first and the second selection switch (S1 and S2) to the control arrangement (STA) when the phase of the clock signal supplied to it via the second selection switch is equal to or greater than the phase of the clock signal (T3) serving as comparison signal.

3. Circuit according to Claim 1 or 2, characterized in that the clock signal distribution circuit (SR) is formed from a multi-level shift register.

4. Circuit according to Claim 1 or 2, characterized in that the clock signal distribution circuit (SR) is formed from a cyclical binary counter with outputs indicating the counter readings.

5. Circuit according to one of Claims 1 to 4, characterized in that digital circuits having an internal signal transit time corresponding to the achievement of phase shifting are used as delay elements (L) of the delay line (LK).

FIG 1

FIG 2